# EUROPEAN PATENT APPLICATION

(11) **EP 1 271 659 A2**
(43) Date of publication of application: **02.01.2003**
(21) Application number: 02396079.2
(22) Date of filing: 29.05.2002
(51) Int. Cl.: H01L 29/93

(54) **A voltage controlled variable capacitor, a double epilayer wafer, and a semiconductor chip**

(30) Priority: 13.06.2001 FI 20011255
(71) Applicant: Micro Analog Systems OY, 02770 Espoo (FI)
(72) Inventor: Mellin, Joni, 02610 Espoo (FI)
(74) Representative: Äkräs, Tapio

(57) **Abstract**

A double epilayer substrate or wafer is used as starting material for integrated circuit technologies, such as CMOS technologies designed for n-type substrates. The double epilayer substrate comprises an n-type top epitaxial layer (301), a thinner buried n-type epitaxial layer (302) having a higher dopant concentration than said top epitaxial layer, and a p-type substrate (303). A varactor is processed inside an n-type pocket or well (300) defined by deep p-type guard rings (304) diffused to form an ohmic contact with the p-type substrate. This deep guard ring (304) isolates the varactor from the surrounding intergrated circuit chip.

## Description

### Field of the Invention

This invention relates generally to semiconductor chips and wafers. The invention also relates to integrated voltage controlled variable capacitors formed on a semiconductor substrate or wafer.

### Background of the Invention

Varactors, i.e. voltage controlled variable capacitors, are widely used in voltage controlled oscillators (VCO) for adjusting the oscillating frequency. More particularly, the oscillating frequency of the VCO is determined by the capacitance value of the varactor, which can be adjusted by a control voltage. Integrated varactors are integrated into the same chip with the remaining oscillator circuit, e.g. by MOS (metal-oxide-semiconductor) or complementary MOS (CMOS) technologies. An integrated varactor produced on a p-type substrate is disclosed in US-A-4973922.

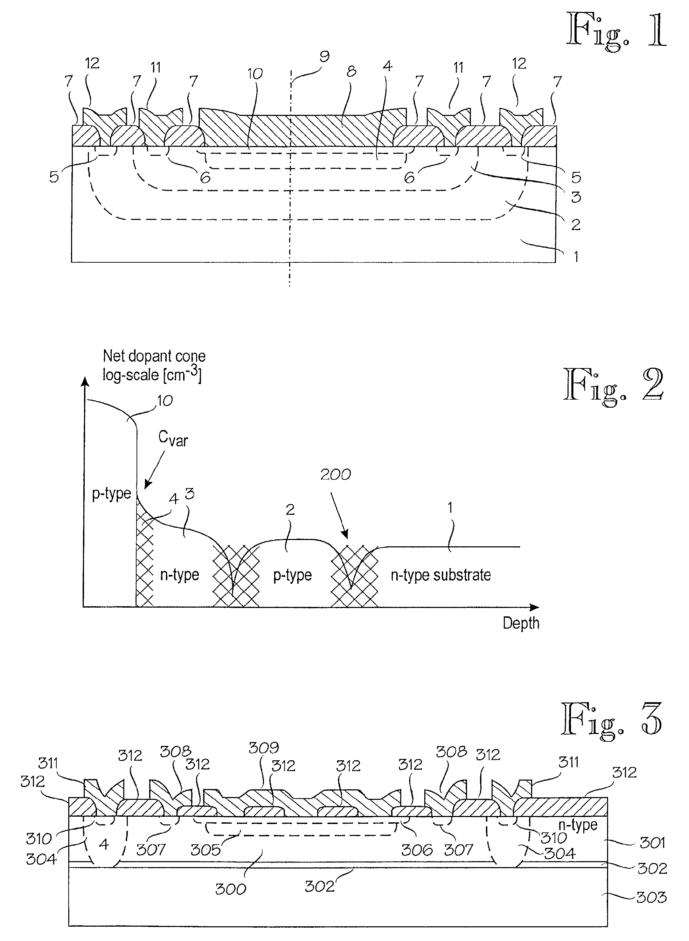

Possibility of using integrated varactors in CMOS technologies using an n-type substrate is in certain applications limited by the supply voltage (Vdd) dependence, which has to be very low (below the ppm-level). This is the case for example with VCXO (Voltage Controlled Crystal Oscillator) and TCVCXO (Temperature Compensated VCXO) products. The TCVCXO and VCXO products use varactors for the crystal oscillation frequency tuning, and no Vdd sensitivity is allowed at all. Integration of a varactor with no Vdd sensitivity into a CMOS technology using n-type wafers as starting material is impossible because the substrate has to be connected to Vdd (i.e. the most positive voltage in the integrated circuit chip). Figure 1 shows an example of a varactor integrated on an n-type substrate 1. The varactor capacitor is formed by a P+ diffusion layer 10 providing the varactor anode and an ohmic contact to a metallic anode terminal 8, and an n-type varactor junction diffusion layer 4, and an n-type varactor well 3 providing the varactor cathode. N+ diffusions 6 provide an ohmic contact between the varactor well (cathode) 3 and a metallic cathode terminal 11. A control voltage Vc is connected to the terminal 11. The n-type well 3 is isolated from the n-type substrate 1 by a deep p-type well 2. The p-type well is connected to a ground potential through an N+ diffusion 5 and a metallic terminal 12. Insulator layers (such as SiO₂) are designated by reference numeral 7.

Figure 2 illustrates a concentration profile at line 9 shown in Figure 1. The varactor capacitor Cvar is formed at the varactor junction 4. The fact that the n-type substrate1 has to be connected to the Vdd means that this hyperabrupt PN-varactor device (or a similar MOS-varactor) isolated from the substrate 1 with a p-type well 2 has too high Vdd dependence. The Vdd dependence is caused by the fact that the Vdd changes the width of the depletion layer 200 formed between the p-well 2 and the n-type substrate 1. The depletion layer 200 extends to both sides of the junction thus narrowing the p-type region under the n-type well 3. The depletion layer width of a reverse biased abrupt junction 200 is proportional to the square root of the voltage across the junction. Therefore, pinched p-well resistance (resistance of region 2) changes as a function of the Vdd. It modulates the reactance of the varactor, thus causing the oscillating frequency sensitive to the Vdd in the final oscillator product.

### Disclosure of the Invention

An object of the invention is to alleviate the above problems relating to the manufacture of voltage controlled variable capacitors and other devices using technologies designed for n-type substrates.

This object is achieved by a voltage controlled variable capacitor, a wafer and an integrated semiconductor chip disclosed in the attached independent claims. Preferred embodiments of the invention are disclosed in the attached dependent claims.

The basic idea of the present invention is use of a double epilayer substrate or wafer as starting material for integrated circuit technologies, such as CMOS technologies designed for n-type substrates. The double epilayer substrate comprises an n-type top epitaxial layer, a thinner buried n-type epitaxial layer having a higher dopant concentration than said top epitaxial layer, and a p-type substrate. This approach eliminates the Vdd dependence of the frequency caused by a integrated varactor processed in said n-type top epitaxial layer. The buried n-type epilayer is preferably weakly doped with As, Sb or some other slowly diffusing dopant. The buried epilayer concentration (i.e. resistivity) is determined by the varactors' maximum allowable parasitic bottom plate capacitance between the buried epilayer and the p-type substrate junction and by the triggering voltage of the parasitic PNP-transistor formed by a p-type well, the n-type top epilayer, and the p-type substrate in the CMOS technology. Both the parasitic PNP-transistor triggering voltage and the bottom-plate capacitance increase as a function of the dopant concentration of the buried n-type epilayer. The parasitic PNP-transistor triggering voltage should be as high as possible, whereas the bottom plate capacitance should be as low as possible. Therefore, the dopant concentration of the buried n-type epilayer varies according to the required varactor characteristics, which may differ from application to application. However, the dopant concentration of the buried epilayer is always higher than that of the top epitaxial layer.

In an embodiment of the invention, the voltage controlled variable capacitor (i.e. a varactor) is processed inside an n-type pocket or well defined by suitable means into the n-type top epitaxial layer. In an embodiment of the invention, the n-type pocket or well is defined by deep p-type guard rings diffused to form an ohmic contact with the p-type substrate, or by other means. This deep guard ring isolates the varactor from the surrounding intergrated circuit chip.

In a further embodiment of the invention, these n-type pockets or wells separated by deep p-type guard rings (or by other means) can be used to isolate sensitive analogue blocks from surrounding digital blocks in mixed signal products. In a still further embodiment of the invention, different supply voltages (e.g. Vdd) are used in these n-type pockets (i.e. multi-power integrated circuit chip is provided, which is difficult in CMOS technologies using conventional n-type wafers).

### Brief Description of the Drawings

The invention will be now described by means of preferred embodiments with reference to the attached drawings, in which
Figure 1 is a cross-sectional view of a conventional varactor manufactured on an n-type substrate,
Figure 2 shows a dopant concentration profile of the varactor shown in Figure 1,
Figure 3 is a cross-sectional view of a varactor according to a preferred embodiment of the invention,
Figure 4 shows a dopant concentration profile of the varactor shown in Figure 3, and
Figure 5 shows a dopant concentration profile of the double epilayer starting material according to the invention.

### Detailed Description

Figure 1 shows an integrated varactor manufactured on a double epilayer substrate or wafer according to the invention. The double epilayer substrate or wafer comprises an n-type top epitaxial layer 301, a thinner buried n-type epitaxial layer 302 having a higher dopant concentration than the top epitaxial layer 302, and a p-type substrate 303. The voltage controlled variable capacitor (i.e. a varactor) is processed inside an n-type pocket or well 300 defined by suitable means into the n-type top epitaxial layer 301. Trenches are an example of such means. In the embodiment shown in Figure 3, the n-type pocket or well 300 is defined by a deep p-type guard ring 304 diffused to extend from the top surface to the bottom of the layer 301 to form metallurgical contact with the p-type substrate 303. At the top of the guard ring 301, a P+ diffusion region 310 is provided in order to provide an ohmic contact to a metallic contact terminal 311. The contact terminal 311 is preferably connected to a ground potential. This deep guard ring 304 isolates the varactor from the surrounding integrated circuit chip. A depletion layer, which is formed between the p-type guard ring 304 and an n-type bulk substrate (CMOS) biased to Vdd, extends practically solely into an n-type region and, therefore, the Vdd dependence of the low resistance (i.e strongly doped) deep guard ring 304 is eliminated.

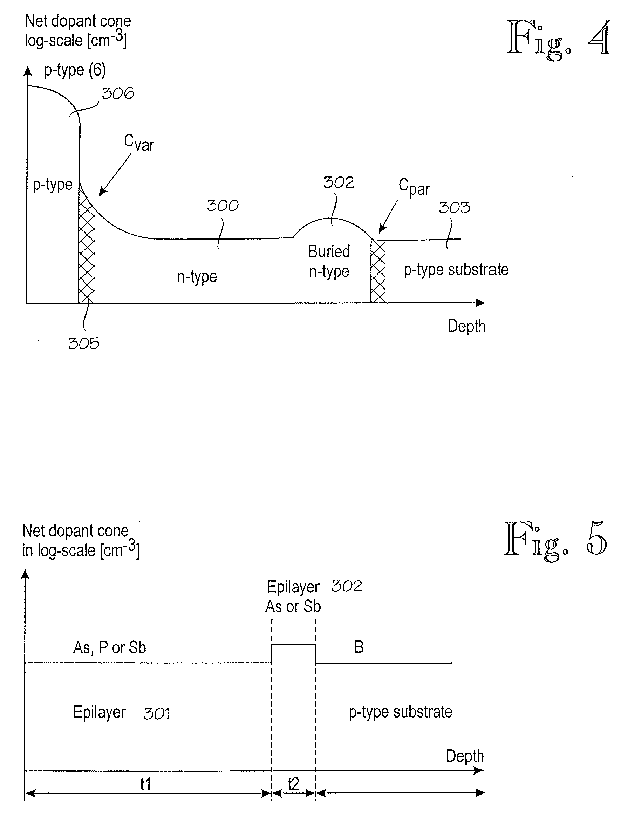

Figure 5 shows a dopant concentration profile of the double epilayer starting material according to the invention. The n-type top epilayer 301 is doped with an n-type dopant, e.g. As, P, or Sb. The buried n-type epilayer 302 is doped with a slowly diffusing n-type dopant, e.g. As or Sb. However, the dopant concentration of the buried epilayer 302 is always higher than that of the top epitaxial layer 301. t1 represents thickness of the top epilayer and t2 represents thickness of the buried epilayer 302.

The varactor inside the n-type pocket or well 300 comprises a P+ diffusion layer 306 forming the varactor anode and an ohmic contact to a metallic anode terminal 309, and an n-type varactor junction diffusion layer 305. The n-type well 300 forms the varactor cathode. N+ diffusions 307 provide an ohmic contact between the varactor well (cathode) 300 and a metallic cathode terminal 308. A control voltage Vc is connected to the terminal 308. The anode terminal 309 may be connected to the ground. Insulator layers (such as SiO₂) are designated by reference numeral 312.

Figure 4 shows a dopant concentration profile of the varactor shown in Figure 3. The varactor capacitance Cvar is located at the varactor junction 305 between the p-type layer 306 and the n-type well 300. A parasitic bottom plate capacitance Cpar exhibits at the junction between the buried n-type epilayer 302 and the p-type substrate. The dopant concentration (i.e. resistivity) of the buried epilayer 302 is determined by the varactors' maximum allowable parasitic bottom plate capacitance Cpar and by the triggering voltage of the parasitic PNP-transistor formed by a p-type well, the n-type top epilayer 301, and the p-type substrate 303 in the CMOS technology. Both the parasitic PNP-transistor triggering voltage and the bottom-plate capacitance Cpar increase as a function of the dopant concentration of the buried n-type epilayer 302. The parasitic PNP-transistor triggering voltage should be as high as possible, whereas the bottom plate capacitance Cpar should be as low as possible. Therefore, the dopant concentration of the buried n-type epilayer 302 varies according to the required varactor characteristics, which may differ from application to application.

The n-type pockets or wells 300 separated by deep p-type guard rings 304 (or by other means) in an integrated semiconductor chip can be used to isolate sensitive analogue blocks from surrounding digital blocks in mixed signal products. Furthermore, it is possible to use different supply voltages Vdd in these n-type pockets 300, which is difficult in CMOS technologies using n-type wafers.

From the description of the preferred embodiments of the present invention it will be apparent to one of skill in the art that other embodiments incorporating the inventive concept may be used. Therefore, the present invention should be limited only by the spirit and scope of the appended claims.

## Claims

1. A voltage controlled variable capacitor formed on a p-type semiconductor substrate and comprising two contact terminals, **characterized by** comprising the following layers in the following order:
a p-type semiconductor layer forming an anode plate of said capacitor and connected to a first one of said terminals,
an n-type semiconductor layer forming a varactor junction,
an n-type well having an n-type top epitaxial layer and a buried n-type epitaxial layer having a different dopant concentration than said top epitaxial layer, said top epitaxial layer forming a cathode plate of said capacitor and being connected to a second one of said terminals, which receives a capacitance control voltage, and
said p-type substrate.

2. A capacitor according to claim 1, **characterized by** said well being defined in said top epitaxial layer and said buried epitaxial layer by a p-type guard ring, which extends through said top semiconductor layer and said buried epitaxial layer to said p-type semiconductor substrate and is connected to a ground potential.

3. A capacitor according to claim 1 or 2, **characterized in that** said buried epitaxial layer is doped weakly by a slowly diffusing dopant.

4. A capacitor according to claim 1, 2 or 3, **characterized in that** said buried epitaxial layer is doped by As or Sb.

5. A capacitor according to claim 1, 2, 3 or 4, **characterized in that** said top epitaxial layer is doped by As, P or Sb.

6. A double epilayer wafer to be used as starting material for complementary metal-oxide semiconductor (CMOS) technologies, **characterized in that** it comprises, in the following order,
an n-type top epitaxial layer,
a buried n-type epitaxial layer having a higher dopant concentration than said top epitaxial layer, and
a p-type substrate.

7. A wafer according to claim 6, **characterized in that** said buried epitaxial layer is doped weakly by a slowly diffusing dopant.

8. A wafer according to claim 6 or 7, **characterized in that** said buried epitaxial layer is doped by As or Sb.

9. A wafer according to claim 6, 7 or 8, **characterized in that** said top epitaxial layer is doped by As, P or Sb.

10. A semiconductor chip comprising electronic devices manufactured by a complementary metal-oxide semiconductor (CMOS) technology on a double epilayer substrate, **characterized in that** said double epilayer substrate comprises an n-type top epitaxial layer, a buried n-type epitaxial layer having a higher dopant concentration than said top epitaxial layer, and a p-type substrate.

11. A semiconductor chip according to claim 10, **characterized in that** at least one of said devices is processed inside an n-type pocket defined in said top epitaxial layer and said buried epitaxial layer by a p-type guard ring, which extends through said top semiconductor layer and said buried epitaxial layer to said p-type substrate and is connected to a ground potential.

12. A semiconductor chip according to claim 10, **characterized in that** at least two different devices in different n-type pockets have different supply voltages.

13. A semiconductor chip according to claim 11 or 12, **characterized in that** a device in at least one n-type pocket is an analogue device and a device in at least one other n-type pocket is a digital device.

14. A semiconductor chip according to any one of claims 10 to 13, **characterized in that** said buried epitaxial layer is doped weakly by a slowly diffusing dopant.

15. A semiconductor chip according to any one of claims 10 to 14, **characterized in that** said buried epitaxial layer is doped by As or Sb.

16. A semiconductor chip according to any one of claims 10 to 15, **characterized in that** said top epitaxial layer is doped by As, P or Sb.

17. A semiconductor chip according to any one of claims 10 to 16, **characterized in that** at least one of said devices is a voltage controlled variable capacitor.
